Europäisches Patentamt

European Patent Office

Office européen des brevets

(19)

(11) Numéro de publication : **0 012 181**
**B1**

(12) # FASCICULE DE BREVET EUROPÉEN

(45) Date de publication du fascicule du brevet :
**07.12.83**

(51) Int. Cl.³ : **H 01 L 31/06, H 01 L 31/18**

(21) Numéro de dépôt : **79104062.9**

(22) Date de dépôt : **19.10.79**

(54) **Convertisseur d'énergie solaire au silicium.**

(30) Priorité : **13.12.78 US 968888**

(43) Date de publication de la demande :
**25.06.80 Bulletin 80/13** ˌ

(45) Mention de la délivrance du brevet :
**07.12.83 Bulletin 83/49**

(84) Etats contractants désignés :
**DE FR GB**

(56) Documents cités :
**DE-A- 1 564 925
DE-A- 2 730 477
US-A- 3 081 370
US-A- 3 460 240
IEEE TRANSACTIONS ON ELECTRON DEVICES, Vol.
ED-25, No. 1, Janvier 1978, New York C.T. SAH et al.
"A High-Low Junction Emitter Structure for Improving
Silicon Solar Cell Efficiency" page 66, 67**

(73) Titulaire : **International Business Machines Corporation
Old Orchard Road
Armonk, N.Y. 10504 (US)**

(72) Inventeur : **Hovel, Harold John
Diane Court
Katonah, New York 10598 (US)**

(74) Mandataire : **Gallois, Gérard
COMPAGNIE IBM FRANCE Département de Propriété
Industrielle
F-06610 La Gaude (FR)**

EP 0 012 181 B1

Jouve, 18, rue St-Denis, 75001 Paris, France

# Convertisseur d'énergie solaire au silicium

## Description

### Domaine technique

La présente invention concerne les cellules solaires au silicium. Une combinaison de matériaux et de caractéristiques structurales a permis d'augmenter le rendement des cellules solaires, c'est-à-dire l'efficacité de la conversion de l'énergie lumineuse des radiations solaires en énergie électrique. Un matériau semi-conducteur, l'arséniure de gallium, semble actuellement être le plus efficace car il permet d'obtenir un rendement théorique d'environ 28 %. Cependant, un autre matériau, le silicium, a été très employé aux fins d'applications afférentes aux dispositifs semiconducteurs et, de ce fait, on dispose d'une quantité considérable de données relatives aux cellules au silicium et à leur fabrication. Le silicium semblerait donc être, du point de vue du coût, un matériau à partir duquel il serait souhaitable de réaliser des cellules solaires, mais jusqu'à présent le rendement de telles cellules n'a pu atteindre 20 %.

Il est également souhaitable, du point de vue du coût, de focaliser ou de concentrer la lumière solaire sur des cellules solaires. Les systèmes qui sont employés à cette fin et qui comportent, par exemple, des lentilles ou des réflecteurs paraboliques sont moins coûteux par unité de surface que le sont les cellules solaires, si bien qu'il est économiquement avantageux de combiner des cellules solaires et de tels systèmes. Un avantage supplémentaire qui résulte de cette concentration de la lumière solaire est qu'elle permet d'augmenter le rendement, dans la mesure où l'on peut contrôler la température.

La présente invention concerne des cellules solaires au silicium permettant d'obtenir un rendement supérieur à 20 %. Cette dernière cellule est particulièrement utile lorsqu'elle est employée avec des systèmes de concentration de la lumière solaire.

### Etat de la technique antérieure

Lors de la conception d'une cellule solaire au silicium, on cherche à augmenter le rendement en utilisant certaines caractéristiques du dispositif, par exemple les champs électriques de glissement, qui facilitent le transport des porteurs ; en impartissant différentes conductivités, pour commander la résistance, à différentes parties d'éléments fonctionnels, à sections multiples, par exemple l'émetteur ; et en établissant des champs de surface arrière pour commander la recombinaison des porteurs minoritaires.

La combinaison de certaines de ces caractéristiques dans un unique dispositif est décrite dans un article de Sah, Lindholm et Fossum paru dans la publication « IEEE Transactions on Electron Devices », Vol. ED25, p. 66, 1978, dispositif dans lequel l'émetteur comporte une région de forte conductivité, de manière à obtenir une faible résistance de feuille, et une région contiguë de faible conductivité, la combinaison de ces deux régions permettant de diminuer le courant d'obscurité. La région de faible conductivité est dopée selon une concentration comprise entre $10^{14}$ et $10^{16}$ atomes par $cm^3$, et l'épaisseur ou la profondeur de la jonction des régions ainsi combinées de l'émetteur est comprise entre 1 et 10 microns. Un champ de surface arrière est préconisé à proximité immédiate du contact ohmique arrière de façon à réduire la recombinaison des porteurs.

La raison pour laquelle l'émetteur comporte deux régions présentant des conductivités différentes est donnée dans le brevet des E.U.A. 3 081 370. Selon ce dernier brevet, si le niveau de dopage dépasse la concentration « dégénérée », ce qui est d'environ $5 \times 10^{18}$ atomes/$cm^3$ dans le cas du silicium, un rétrécissement de l'intervalle de bande se produit, ce qui provoque une absorption excessive à proximité de la surface du silicium et une médiocre collecte des porteurs engendrés optiquement depuis l'émetteur. Ceci peut être évité, selon ledit brevet, en ramenant le niveau de dopage à une valeur inférieure à $5 \times 10^{18}$ atomes/$cm^3$, et des champs électriques de glissement peuvent être incorporés à l'émetteur et à la base pour faciliter la collecte des porteurs minoritaires engendrés optiquement. Par ailleurs, la largeur de l'émetteur ou la profondeur de la jonction est de 2 à 4 microns dans le cas du dispositif décrit dans ledit brevet et les niveaux de dopage de la base étaient compris entre $10^{17}$ et $10^{22}$ atomes/$cm^3$. Toutefois, ces dispositifs présentent des limitations en ce qui concerne leurs performances.

Dans un autre document, le brevet US-A-3 460 240, il est décrit un procédé de fabrication d'une cellule solaire, allant dans un sens opposé. L'émetteur présente une épaisseur très faible, dé 0,5 à 1 μ, et la concentration des impuretés décroît de façon régulière, de $5 \times 10^{20}$ $cm^{-3}$ à une valeur de $10^{15}$ $cm^{-3}$ près de la jonction. La base comporte deux parties, l'une dans laquelle la concentration augmente d'une valeur de $10^{15}$ $cm^{-3}$ à une valeur de $10^{19}$-$10^{20}$ $cm^{-3}$ et, par suite du gradient important, peut se développer un champ de glissement, et l'autre ou la concentration est constante et conserve une valeur de $10^{19}$-$10^{20}$ $cm^{-3}$. Le but recherché cependant dans ce procédé est de permettre d'éviter la fixation de la couche protectrice de quartz sur la cellule fabriquée séparément, en faisant simplement croître des couches successives de silicium N et P sur un substrat de quartz. Aucune justification particulière de la structure telle que décrite n'est cependant donnée.

### Description de l'Invention

L'invention fait appel à l'emploi d'un émetteur comportant une région de forte conductivité et une région de faible conductivité, disposé sur une base comportant une région de faible conductivité et une région de forte conductivité. La structure de la cellule solaire diffère légèrement selon qu'il s'agit d'un dispositif du type p+p nn+ ou d'un dispositif n+n pp+. Dans les deux cas, la région fortement conductrice dudit émetteur permet de minimiser à la fois la résistance de feuille et la résistance de contact. Cette région présente un niveau de dopage de $10^{19}$ atomes ou davantage par $cm^3$ et son épaisseur est comprise entre 0,1 et 0,2 micron. Dans la région de faible conductivité, afin de minimiser le rétrécissement de l'intervalle de bande tout en conservant une durée de vie satisfaisante des porteurs de telle sorte que les porteurs engendrés optiquement depuis l'émetteur puissent être transportés en plus grand nombre jusqu'à la jonction p-n, le niveau de dopage est maintenu à une valeur comprise entre $10^{16}$ et $10^8$ porteurs par $cm^3$. L'émetteur comportant une région fortement dopée et une région modérément dopée permet d'améliorer la collecte du courant photo-électrique et de diminuer le courant d'obscurité indésiré, et, partant, d'augmenter la valeur de la tension obtenue en sortie. La performance peut être augmentée davantage encore en établissant un champ électrique dans l'une ou l'autre desdites régions de l'émetteur, ou dans ces deux régions, en diminuant graduellement le niveau de dopage au fur et à mesure que l'on s'éloigne de la surface semi-conductrice. Ce champ électrique contribue à l'augmentation du courant photo-électrique et permet de diminuer davantage encore le courant d'obscurité.

L'épaisseur de cette région modérément dopée de l'émetteur est comprise entre 0,3 et 0,9 micron, la jonction p-n étant de ce fait disposée à une distance d'environ 1 micron ou moins au-dessous de la surface. Les niveaux de dopage et les épaisseurs des régions qui se trouvent au-dessous de l'émetteur doivent être tels que l'on puisse obtenir une résistance de feuille suffisamment faible. Une grille de contact est appliquée à la surface de l'émetteur de la cellule solaire de manière à minimiser la résistance série de celle-ci. Cela est particulièrement important dans le cas des cellules solaires utilisées avec concentration de la lumière solaire, le courant photo-électrique devenant alors très élevé. L'importance de cette grille de contact est soulignée dans l'article de N. Convers Wyeth paru dans la publication « Solid State Electronics », Vol. 20, p. 629, 1977.

Les résistances de feuille devraient être égales ou inférieures à environ 500 ohms/□ dans le cas de cellules solaires utilisées avec concentration de la lumière solaire. Dans la présente invention, l'épaisseur et les niveaux de dopage des deux régions de l'émetteur sont choisies de manière à satisfaire cette condition tout en minimisant les effets du rétrécissement de l'intervalle de bande et de la diminution de la durée de vie des porteurs minoritaires dans l'émetteur. En particulier, le niveau de dopage de $10^{16}$ à $10^{18}$ atomes par $cm^3$

de la région de faible conductivité permet de réduire ces effets au minimum. On notera que, dans le cas du dispositif décrit dans l'article précité Sah et al, le niveau de dopage de la région correspondante était compris entre $10^{14}$ et $10^{16}$ atomes par $cm^3$.

Le choix du profil du dopage de la base de la cellule solaire varie selon qu'il s'agit d'un dispositif du type n+n pp+ ou du type p+p nn+. Dans ce dernier cas, le niveau de dopage de la base est compris entre $10^{13}$ et $10^{16}$, et la durée de vie des porteurs minoritaires est la plus longue possible. Lorsque la lumière solaire est concentrée sur ce type de dispositif, la densité des trous et des électrons engendrés par la lumière dépasse la densité du dopage dans la base, c'est-à-dire qu'une « modulation de conductivité » se produit. La densité des porteurs en fonction de la distance diminue, dans la plus grande partie de la base, au fur et à mesure que l'on s'éloigne de la surface, et comme le coefficient de diffusion des électrons est supérieur au coefficient de diffusion des trous, il se produit aux bornes de la base une différence de potentiel ou tension dont la polarité est telle qu'elle s'ajoute à la tension de sortie du dispositif. La région très fortement dopée qui se trouve dans la partie arrière du dispositif fournit un « champ de surface arrière » qui permet de réduire au minimum les recombinaisons indésirables dans la base et d'obtenir un contact ohmique présentant une très faible résistance.

Dans le cas d'un dispositif du type n+n pp+, la tension engendrée dans la base par suite de la modulation de conductivité se soustrait de la tension de sortie de la cellule au lieu de s'ajouter à celle-ci. Pour cette raison, le niveau de dopage de la base est rendu plus élevé dans ce dispositif, soit de $10^{16}$ à $10^{18}$ atomes par $cm^3$, de manière à réduire au minimum la modulation de conductivité. La diminution de la durée de vie des porteurs minoritaires dans la base qui résulte de cette augmentation du niveau de dopage devrait normalement se traduire par une perte par recombinaison accrue mais cette perte peut être compensée en établissant un gradient de dopage dans la base de manière à créer l'aide d'un champ électrique de glissement. Par exemple, le niveau de dopage de la base peut passer de $10^{16}$ atomes par $cm^3$, à proximité du bord de la jonction, à $10^{18}$ atomes par $cm^3$ à une distance de 20 à 100 microns du bord de cette jonction. Ce champ électrique de glissement contribue en outre à réduire au minimum la modulation de conductivité, à augmenter le courant photo-électrique et à diminuer le courant d'obscurité. Une région fortement dopée est établie au niveau de la surface arrière du dispositif afin également de réduire au minimum les recombinaisons et de faciliter l'obtention d'un contact ohmique arrière présentant une faible résistance.

L'épaisseur de la base dans l'un ou l'autre de ces dispositifs, du type n+n pp+ ou p+p nn+, est comprise entre 50 et 450 microns, et est de préférence inférieure à la longueur efficace de diffusion des porteurs minoritaires dans la base, selon l'équation 1 ci-après :

$$L_{eff}^{-1} = \sqrt{(gE/2kT)^2 + (1/L)^2} \qquad (1)$$

où E est l'amplitude du champ électrique de glissement établi au moyen du gradient de dopage, k est la constante de Boltzmann, T est la température, et L est la longueur de diffusion.

La combinaison de ces caractéristiques et de ces dimensions dans l'émetteur et dans la base de la cellule solaire permet d'obtenir une cellule solaire du type n+n pp+ ou p+p nn+ présentant un rendement égal ou supérieur à 20 %.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève description des figures

La Figure 1 représente un dispositif p + pn n+ conforme à la présente invention.

La Figure 2 représente un dispositif n+n pp+ conforme à la présente invention.

### Meilleur mode de réalisation de l'invention

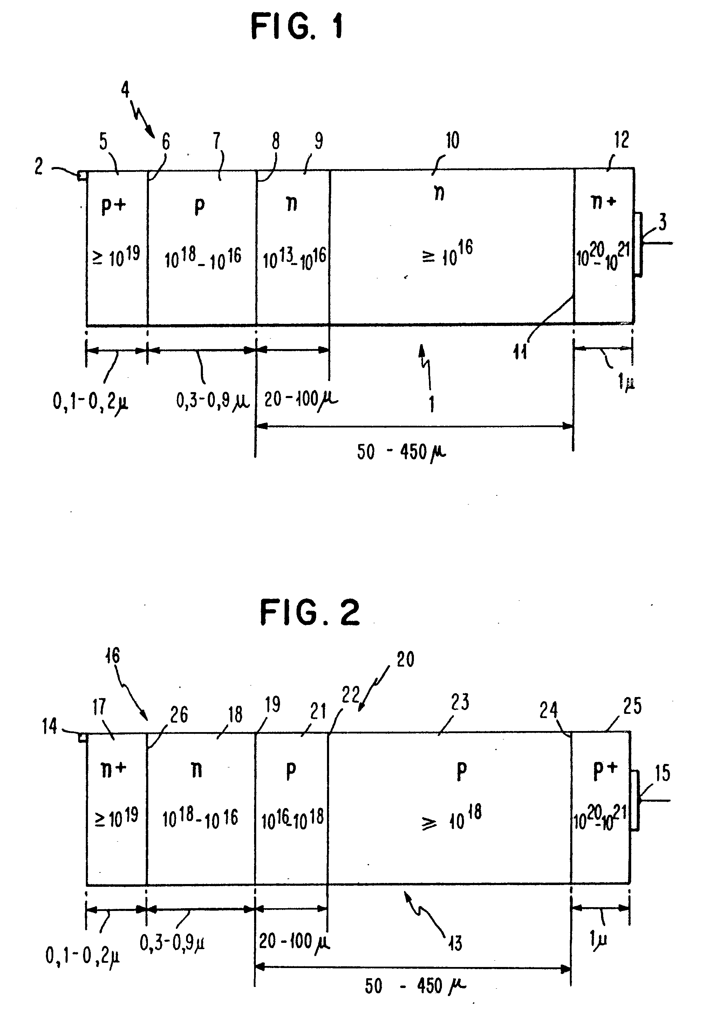

On a représenté sur la Figure 1 une cellule solaire semi-conductrice au silicium 1 du type p+p nn+ comportant des contacts ohmiques 2 et 3 à ses extrémités opposées. La cellule comporte un émetteur 4 composé d'une région de forte conductivité 5 contiguë, par l'interface 6, avec une région de faible conductivité 7, laquelle forme, à son tour, une jonction p-n 8 avec une région 9 d'un type de conductivité opposé qui, avec une région 10, constitue la base de la cellule. Un champ de surface arrière 11 est obtenu au moyen d'une région 12 présentant une conductivité plus élevée et à laquelle est connecté un contact ohmique 3.

L'épaisseur totale de l'émetteur 4 à deux sections est telle que la jonction p-n 8 se trouve à une distance de 1 micron environ au-dessous de la surface. La région 5 de forte conductivité de l'émetteur 4 présente une très faible épaisseur, de 0,1 à 0,2 micron, et une conductivité très élevée p+ de façon à réduire la résistance de feuille. Le niveau de dopage de la région 5 est de l'ordre de $10^{19}$ atomes ou davantage par $cm^3$, le niveau de dopage le plus élevé étant adjacent à la surface à proximité du contact 2, afin de réduire au minimum la résistance de contact. La région 7 de l'émetteur 4 a une épaisseur comprise entre 0,3 et 0,9 micron et peut avoir un gradient de dopage allant de $10^{18}$ atomes par $cm^3$, à proximité de l'interface 6, à $10^{16}$ atomes par $cm^3$ au niveau de la jonction p-n 8.

Ce profil de dopage offre trois avantages. Il permet tout d'abord d'établir un champ de glissement qui facilite le transport des porteurs. Par ailleurs, la concentration modérée d'impureté permet, d'une part, d'éviter le rétrécissement de l'intervalle de bande qui se produit lorsqu'on utilise des niveaux de dopage plus élevés, et, d'autre part, d'obtenir une durée de vie relativement importante des porteurs minoritaires.

De l'autre côté de la jonction p-n 8, la région 9 de type de conductivité opposé et d'une épaisseur de 20 à 100 microns est dopée selon une concentration de $10^{13}$ à $10^{16}$ atomes par $cm^3$ afin d'augmenter au maximum la durée de vie et d'obtenir une modulation de la conductivité. La seconde région 10 de la base, de même type de conductivité est uniformément dopée selon une concentration d'environ $10^{16}$ atomes par $cm^3$ ou plus. La région 12 très fortement dopée présente une concentration de $10^{20}$ à $10^{21}$ atomes par $cm^3$.

On a représenté sur la Figure 2 une cellule solaire semi-conductrice au silicium 13 du type n+n pp+ comportant à ses extrémités opposées des contacts ohmiques 14 et 15. La cellule comporte un émetteur 16 composé d'une région de forte conductivité 17 contiguë avec une région de faible conductivité 18 qui forme une jonction p-n 19 avec une base 20 du type de conductivité opposé. La base 20 comporte une région 21, dans laquelle le niveau de concentration va graduellement de $10^{16}$ atomes par $cm^3$, à proximité de la jonction 19, à $10^{18}$ atomes par $cm^3$ à proximité de la séparation 22 entre la région 21 et une région 23 qui présente un dopage uniforme. Un champ de surface arrière 24 est obtenu grâce à une région 25 de forte conductivité dont le niveau de dopage est compris entre $10^{20}$ et $10^{21}$ atomes par $cm^3$.

L'épaisseur totale de l'émetteur 16 est telle que la jonction p-n se trouve à une distance d'1 micron environ au-dessous de la surface. La région 17 de forte conductivité de l'émetteur 16 présente une très faible épaisseur qui est comprise entre 0,1 et 0,2 micron et un niveau de dopage élevé qui est supérieur à $10^{19}$ atomes par $cm^3$, de manière à réduire les résistances de feuille et de contact. La région 18 de l'émetteur a une épaisseur comprise entre 0,3 et 0,9 micron et peut présenter un gradient de dopage allant en décroissant de $10^{18}$ atomes par $cm^3$ à proximité de la séparation 26, à $10^{16}$ atomes par $cm^3$ au niveau de la jonction 19 avec la base 20. Cet émetteur à deux parties présentant des conductivités différentes offre les mêmes avantages que ceux précédemment décrits à propos du dispositif de la Figure 1.

De l'autre côté de la jonction 19, la base 20 se compose d'une première région 21 d'une épaisseur de 20 à 100 microns présentant une concentration d'impureté allant graduellement de $10^{16}$ atomes par $cm^3$ au niveau du bord de la jonction 19, à $10^{18}$ atomes par $cm^3$ au niveau de la séparation 22. Cette première région à dopage graduel permet d'établir dans la base 20 un champ de glissement qui aide à porter le courant photoélectrique à sa valeur maximum et le courant d'obscurité à sa valeur minimum, cependant que le niveau de concentration élevé de $10^{16}$ atomes ou davantage par $cm^3$ permet de réduire au minimum la modulation de la conductivité dans cette base. La seconde région 23 de la base 20 est uniformément dopée selon une concentration d'environ $10^{18}$ atomes par $cm^3$ ou plus. Une région 25 fortement dopée et présentant un niveau de concentration compris entre $10^{20}$ et $10^{21}$ atomes par $cm^3$ permet d'établir un champ de surface arrière 24 et facilite l'obtention d'une faible résistance de contact avec le contact métallique 15.

Lors de la fabrication du dispositif de la Figure 1 ou de la Figure 2, le substrat du départ est choisi avec soin de telle sorte que l'on puisse obtenir une longue durée de vie des porteurs minoritaires. Plus cette durée de vie est longue, plus le transport des porteurs, du point où ils sont engendrés jusqu'à la jonction p-n, est efficace, et moins l'épaisseur de la base, qui doit être telle qu'elle puisse être traversée par les porteurs moyens, présente un caractère critique. Le champ de surface arrière est établi en donnant à la région fortement dopée 12 ou 25 une épaisseur de 1 micron.

Le matériau de départ pour réaliser la base du dispositif p+p nn+ de la Figure 1 est du silicium de type n dopé selon une concentration de $10^{13}$ à $10^{16}$ atomes par $cm^3$ au moyen d'une impureté telle que du phosphore ou de l'arsenic. La région arrière fortement dopée 12 peut être réalisée par implantation ionique ou par diffusion d'arsenic ou de phosphore. La base doit en principe présenter une longue durée de vie pour les porteurs minoritaires et un faible niveau de dopage de telle sorte qu'une modulation de la conductivité se produise.

Dans le cas de la base du dispositif n+n pp+ de la Figure 2, le matériau de départ pour réaliser la région 23 est du silicium de type p dopé selon une concentration d'environ $10^{18}$ atomes par $cm^3$ au moyen d'une impureté telle que du bore, de l'aluminium ou du gallium. La région 21, qui est celle du champ de glissement, peut être réalisée en faisant croître épitaxialement une couche de silicium sur la région 23. Le gradient de dopage, qui va de $10^{16}$ atomes par $cm^3$ au niveau de la jonction 19 à $10^{18}$ atomes par $cm^3$ au niveau de la séparation 22 peut être réalisé en procédant à une rétrodiffusion du dopant depuis la région 23 ou en diminuant la concentration du dopant supplémentaire de nature gazeuse qui est employé lors de la croissance épitaxiale de la couche 21. Le niveau de dopage est élevé dans les deux régions de la base de façon à réduire au minimum la modulation de la conductivité. La durée de vie doit encore être aussi longue que possible afin que le courant photo-électrique ait une valeur maximum et que le courant d'obscurité soit réduit au minimum. La région fortement dopée p+25 à l'arrière du dispositif peut être réalisée par implantation ionique ou par diffusion d'une impureté telle que du bore, de l'aluminium ou du gallium.

Les deux régions, 5 et 7, de l'émetteur de la Figure 1 ou les deux régions, 17 et 18, de l'émetteur de la Figure 2 peuvent être réalisées par implantation ionique dans la tranche qui contient déjà les régions 9 et 10 de la base de la Figure 1 ou les régions 21 et 23 de la base de la Figure 2, respectivement, ou par croissance épitaxiale des couches 5 et 7 ou 17 et 18, respectivement, ou au moyen d'une combinaison des techniques de croissance épitaxiale et d'implantation ionique. Plusieurs doses d'ions et plusieurs énergies d'implantation peuvent être choisies en combinaison de manière à obtenir les niveaux de dopage et les épaisseurs désirés pour ces deux régions émetteur. Selon une autre solution, le niveau de dopage et l'épaisseur de chacune de ces régions de l'émetteur peuvent être aisément commandés pendant une étape de croissance épitaxiale. Des techniques de croissance épitaxiale et d'implantation ionique peuvent facilement être combinées de façon à obtenir le profil désiré de l'émetteur. Les deux émetteurs 4 ou 16 présentent une région uniformément dopée et une région présentant un gradient de dopage (pour établir un champ électrique de glissement) peuvent aussi être facilement obtenus par ces techniques.

Après l'introduction d'impuretés, dans le cas d'une implantation ionique, il convient de procéder avec soin à l'opération de recuit afin que la durée de vie dans la base ne soit pas ramenée à une valeur inférieure à un minimum admissible. Ainsi que le comprendra l'homme de l'art, l'opération de recuit peut être effectuée, par exemple, au moyen d'un faisceau électronique ou d'un faisceau laser. Un recuit thermique peut également être jugé acceptable.

Bien que l'émetteur 4 ou 16 soit de préférence réalisé par implantation ionique et/ou par croissance épitaxiale, le même résultat peut éventuellement être obtenu, ainsi que le comprendra l'homme de l'art, par diffusion ou en combinant une diffusion avec une implantation ionique et/ou une croissance épitaxiale.

On a décrit ci-dessus les impératifs fonctionnels afférents à une cellule solaire au silicium présentant un rendement élevé. Cette cellule peut être employée avec une intensité quelconque de la lumière du soleil, mais est particulièrement avantageuse lorsque la lumière du soleil est concentrée.

Ainsi que le comprendra l'homme de l'art, quelques modifications peuvent être apportées à la présente invention. Par exemple, lorsqu'un champ de glissement est établi pour la région 21, la base 20 est toute entière conditionnée de telle sorte que, si la durée de vie est suffisamment longue, le besoin de ce champ de glissement peut être réduit. De même, si la durée de vie de la région 7 ou de la région 18 de l'émetteur est suffisamment longue, un champ de glissement est inutile dans ces régions. Par ailleurs, les techniques d'implantation ionique, de croissance épitaxiale et de diffusion peuvent être combinées dans une certaine mesure pour réaliser les régions désirées d'émetteur, de base et de champ de surface arrière.

On a décrit ci-dessus une cellule solaire au silicium présentant un rendement élevé, supérieur à 20 %, et dans laquelle les effets contradictoires des caractéristiques structurelles destinées à améliorer la performance sont maîtrisés par des combinaisons de structures physiques et de gradients d'impuretés.

## Revendications

1. Convertisseur d'énergie solaire au silicium, comprenant sur sa surface un émetteur (4, 16) pourvu d'un contact ohmique (2, 14), ledit émetteur formant une jonction p-n (8, 19) avec une région de base (9, 10, 12 ; 21, 23, 25) à 1 micron environ au-dessous de ladite surface caractérisé en ce que :

— l'émetteur est en deux parties distinctes, l'une (5, 17) située adjacente au contact ohmique d'émetteur, de forte conductivité présentant un niveau de dopage supérieur à $10^{19}$ atomes/cm$^3$ et une épaisseur comprise entre 0,1 et 0,2 micron, l'autre (7, 18) située adjacente à la jonction p-n de faible conductivité présentant un niveau de dopage compris entre $10^{18}$ et $10^{16}$ atomes/cm$^3$ et une épaisseur comprise entre 0,3 et 0,9 micron et en ce que

— la base, dont l'épaisseur est comprise entre 50 et 450 microns comporte une partie de faible conductivité (9, 10, 21, 23) et une partie de forte conductivité (12, 25), fournissant un champ de surface arrière, à proximité immédiate d'un contact ohmique (3, 15) éloigné de ladite jonction p-n,

— la partie de faible conductivité de la base étant du type n et ayant un niveau de dopage compris entre $10^{13}$ et $10^{16}$ atomes/cm$^3$ lorsque l'émetteur (4) est du type p$^+$/p et étant du type p et ayant un niveau de dopage compris entre $10^{16}$ et $10^{18}$ atomes/cm$^3$ lorsque l'émetteur (16) est du type n$^+$/n.

2. Convertisseur selon la revendication 1 caractérisé en ce que ladite partie (7, 18) de faible conductivité dudit émetteur présente un niveau de dopage variant de $10^{18}$ atomes/cm$^3$ à proximité immédiate de ladite partie (5) de forte conductivité, à $10^{16}$ atomes/cm$^3$ à proximité immédiate de ladite jonction p-n (8, 19).

3. Convertisseur selon la revendication 1 ou 2 caractérisé en ce que la partie (5, 17) de forte conductivité de l'émetteur (4, 16) comprend un champ de glissement.

4. Convertisseur selon l'une quelconque des revendications 1 à 3 caractérisé en ce que l'épaisseur de la base est inférieure à la longueur efficace de diffusion des porteurs minoritaires dans la base.

5. Convertisseur selon l'une quelconque des revendications 1 à 4 caractérisé en ce que la partie (9, 10) de faible conductivité de la base de type n avec un émetteur p$^+$/p comporte une partie (9) d'une épaisseur de 20 à 100 microns adjacente à la jonction p-n dopée selon une concentration de $10^{13}$ atomes/cm$^3$ à $10^{16}$ atomes/cm$^3$ et une seconde partie (10) uniformément dopée.

6. Convertisseur selon l'une quelconque des revendications 1 à 4 caractérisé en ce que la partie (21, 23) de faible conductivité de la base de type p avec un émetteur n$^+$/n comporte une partie (21) d'une épaisseur de 20 à 100 microns adjacente à la jonction p-n et dont la concentration de dopage varie graduellement de $10^{16}$ atomes/cm$^3$ à proximité de la jonction p-n jusqu'à $10^{18}$ atomes/cm$^3$ à son autre extrémité et une partie (23) uniformément dopée.

7. Convertisseur selon l'une quelconque des revendications 1 à 6 caractérisé en ce que la partie de forte conductivité (12, 25) de la base a un niveau de dopage compris entre $10^{20}$ et $10^{21}$ atomes/cm$^3$ et une épaisseur de 1 micron.

## Claims

1. A silicon solar energy converter comprising on the surface thereof an emitter (4, 16) having an ohmic contact (2, 14) and forming a p-n junction (8, 19) with a base region thereof (9, 10, 12 ; 21, 23, 25) approximately 1 micrometer beneath said surface, characterized in that :

— said emitter has two distinct portions, one of which (5, 17) is a high conductivity region adjacent to said ohmic contact and has a doping level of greater than $10^{19}$ atoms per cm$^3$ and a thickness between 0.1 and 0.2 micrometer, and the other of which (7, 18) is a low conductivity region adjacent to said p-n junction and has a doping level between $10^{18}$ and $10^{16}$ atoms per cm$^3$ and a thickness between 0.3 and 0.9 micrometer, and in that :

— the base, the thickness of which is between 50 and 450 micrometers, has a low conductivity portion (9, 10, 21, 23) and a high conductivity portion (12, 25) providing a back surface field, adjacent to an ohmic contact (3, 15) remote from said p-n junction,

— the low conductivity portion of the base being of the n type and having a doping level between $10^{13}$ and $10^{16}$ atoms per cm$^3$ when said emitter (4) is of the p$^+$/p type, and being of the p type and having a doping level between $10^{16}$ and $10^{18}$ atoms per cm$^3$ when the emitter (16) is of the n$^+$/n type.

2. A converter according to claim 1, characterized in that said low conductivity portion (7, 18) of said emitter has a doping level varying from $10^{18}$ atoms per cm$^3$ adjacent to said high conductivity portion (5) to $10^{16}$ atoms per cm$^3$ adjacent to said p-n junction (8, 19).

3. A converter according to claim 1 or 2, characterized in that the high conductivity portion (5, 17) of said emitter (4, 16) includes a drift field.

4. A converter according to any one of claims 1 to 3, characterized in that the thickness of the base is less than the effective minority carrier diffusion length in said base.

5. A converter according to any one of claims 1 to 4, characterized in that the n type low conductivity portion (9, 10), of the base, where the emitter is of the p$^+$/p type, comprises a portion (9) 20 to 100 micrometer thick that is adjacent to the p-n junction and has an impurity level between $10^{13}$ and $10^{16}$ atoms per $cm^3$ and a second portion (10) that has a uniform doping level.

6. A converter according to any one of claims 1 to 4, characterized in that the p type low conductivity portion (21, 23) of the base, where the emitter if of the $n^+/n$ type, comprises a portion (21) 20 to 100 micrometer thick that is adjacent to the p-n junction and has a doping level that varies gradually from $10^{16}$ atoms per $cm^3$ near said p-n junction to $10^{18}$ atoms per $cm^3$ at its other end and a second portion (23) that has a uniform doping level.

7. A converter according to any one of claims 1 to 6, characterized in that the high conductivity portion (12, 25) of the base has a doping level between $10^{20}$ and $10^{21}$ atoms per $cm^3$ and a thickness of 1 micrometer.

**Ansprüche**

1. Sonnenenergiewandler aus Silizium mit einem auf seiner Oberflaeche angeordneten Emitter (4, 16), der einen ohmischen Kontakt (2, 14) aufweist, wobei der Emitter zusammen mit der Basiszone (9, 10, 12 ; 21, 23, 25) eine ungefaehr um einen Mikron unten der Oberflaeche liegende p-n Trennflaeche (8, 9) bildet, dadurch gekennzeichnet, dass :

— der Emitter aus zwei getrennten Teilen besteht, wobei der eine (5, 17) stark leitfaehige, an dem ohmischen Kontakt mit dem Emitter anliegende, ein Dotierungsniveau ueber $10^{19}$ Atom/$cm^3$ und eine Dicke zwischen 0,1 und 0,2 Mikron aufweist, und der andere (7, 18) schwach leitfaehige, an der p-n Trennflaeche anliegende, ein Dotierungsniveau zwischen $10^{18}$ und $10^{16}$ Atom/$cm^3$ und eine Dicke zwischen 0,3 und 0,9 Mikron aufweist,

— die Basis mit einer Dicke zwischen 50 und 450 Mikron einen schwach leitfaehigen Teil (9, 10 ; 21, 23) und einen stark leitfaehigen Teil (12, 25), der ein rueckseitiges Oeberflaechen-Feld unmittelbar an dem ohmischen mit Abstand von der p-n Trennflaeche liegenden Kontakt (3, 15) schafft,

— wobei der schwach leitfaehige Teil der Basis den Leitungstyp n und ein Dotierungsniveau zwischen $10^{13}$ und $10^{16}$ Atom/$cm^3$ aufweist, wenn der Emitter (4) $p^+/p$ ist, und den Leitungstyp p und ein Dotierungsniveau zwischen $10^{16}$ und $10^{18}$ Atom/$cm^3$ aufweist, wenn der Emitter (16) $n^+/n$ ist.

2. Sonnenenergiewandler nach Anspruch 1, dadurch gekennzeichnet, dass der schwach leitfaehige Teil (7, 18) des Emitters ein Dotierungsniveau aufweist, das zwischen $10^{18}$ Atom/$cm^3$ unmittelbar an dem stark leitfaehigen Teil (5) und $10^{16}$ Atom/$cm^3$ unmittelbar an der p-n Trennflaeche (8, 19) liegt.

3. Sonnenenergiewandler nach Anspruch 1 oder 2, dadurch gekennzeichnet, dass der stark leitfaehige Teil (5, 17) des Emitters (4, 16) ein Driftfeld einschliesst.

4. Sonnenenergiewandler nach einem der Ansprueche 1 bis 3, dadurch gekennzeichnet, dass die Dicke der Basis kleiner als die effektive Diffusionslaenge der Minoritaetstraeger in der Basis ist.

5. Sonnenenergiewandler nach irgendeinem der Ansprueche 1 bis 4, dadurch gekennzeichnet, dass der schwach leitfaehige Teil (9, 10) der Basis des Leitungstyps n mit einem Emitter $p^+/p$ einen an der p-n Trennflaeche anliegenden Teil (9) mit einer Dicke von 20 bis 100, der mit einer Konzentration von $10^{13}$ bis $10^{16}$ Atom/$cm^3$ dotiert ist, und einen zweiten gleichmaessig dotierten Teil (10) aufweist.

6. Sonnenenergiewandler nach irgendeinem der Ansprueche 1 bis 4, dadurch gekennzeichnet, dass der schwach leitfaehige Teil (21, 23) der Basis des Leitungstyps p mit einem Emitter $n^+/n$ einen Teil (21) mit einer Dicke von 20 bis 100, dessen Dotierungskonzentration von $10^{16}$ Atom/$cm^3$ unmittelbar an der p-n Trennflaeche bis $10^{18}$ Atom/$cm^3$ an ihrem anderen Ende stufenweise steigt, und einen gleichmaessig dotierten Teil (23) aufweist.

7. Sonnenenergiewandler nach irgendeinem der Ansprueche 1 bis 6, dadurch gekennzeichnet, dass der stark leitfaehige Teil (12, 25) der Basis ein zwischen $10^{20}$ und $10^{21}$ Atom/$cm^3$ liegendes Dotierungsniveau und eine Dicke von einem Mikron aufweist.

# FIG. 1

| p + | p | n | n | n + |
|---|---|---|---|---|
| $\geq 10^{19}$ | $10^{18} - 10^{16}$ | $10^{13} - 10^{16}$ | $\geq 10^{16}$ | $10^{20} - 10^{21}$ |

0,1-0,2μ    0,3-0,9μ    20-100μ

50 - 450 μ

# FIG. 2

| n + | n | p | p | p + |
|---|---|---|---|---|
| $\geq 10^{19}$ | $10^{18} - 10^{16}$ | $10^{16} - 10^{18}$ | $\geq 10^{18}$ | $10^{20} - 10^{21}$ |

0,1-0,2μ    0,3-0,9μ    20-100μ

50 - 450 μ